# EUROPEAN PATENT SPECIFICATION

(11) **EP 0 280 370 B1**
(45) Date of publication and mention of the grant of the patent: **15.09.1993**
(21) Application number: 88200304.9
(22) Date of filing: 22.02.1988
(51) Int. Cl.: H01L 29/78, G02F 1/133

(54) **Thin film transistors, display devices incorporting such transistors, and methods for their fabrication**
Dünnfilmtransistoren, Anzeigeanordnungen mit solchen Transistoren und Verfahren zu deren Herstellung
Transistors à couche mince, dispositifs d'affichage les comprenant et leurs méthodes de fabrication

(30) Priority: 27.02.1987 GB 8704714
(43) Date of publication of application: 31.08.1988
(73) Proprietor: PHILIPS ELECTRONICS UK LIMITED, Croydon CR9 3QR (GB); Philips Electronics N.V., 5621 BA Eindhoven (NL)
(72) Inventor: Nicholas, Keith Harlow, Redhill Surrey RH1 5HA (GB)
(74) Representative: Williamson, Paul Lewis

(56) References cited:
- US-A- 4 633 284
- PATENT ABSTRACTS OF JAPAN, vol. 10, no. 184 (E-415)[2240], 27th June 1986; & JP-A-61 32 474 (HITACHI LTD) 15-02-1986
- IBM TECHNICAL DISCLOSURE BULLETIN, vol. 29, no. 5, October 1986, pages 2224-2226, New York, US; "Thin film field-effect transistor"
- PROCEEDINGS OF THE S.I.D., vol. 25, no. 1, 1984, pages 11-16, SID, Los Angeles, CA, US; K. SUZUKI et al.: "A 220 x 240 pixel a-Si TFT matrix transmission liquid crystal display"

## Description

This invention relates to thin film transistors, hereinafter referred to as TFTs, and their method of fabrication. The invention is concerned particularly with TFTs of the type comprising a support having an insulative surface, first and second thin film electrodes carried on the support, the second electrode being spaced from the first electrode in a direction substantially orthogonal to the support, semiconductor material extending between the first and second electrodes and in contact therewith for providing a channel region, and a gate electrode layer extending in a direction substantially orthogonal to the support and which is spaced from the semiconductor material by a gate insulator layer. The invention relates also to arrays of such TFTs suitable for use in active matrix display devices.

Such a TFT, or more precisely a thin film field effect transistor, structure is sometimes referred to as a vertical TFT as the channel region of the device extends substantially vertically of the support.

TFTs fabricated from amorphous silicon material are commonly used as switching elements for individual picture elements in active matrix-addressed display devices such as liquid crystal displays, and particularly those display devices intended to display TV pictures. The display devices comprise a large area matrix array of picture elements arranged in rows and columns with each picture element having an associated one or more TFTs carried on a substrate of the device and serving as switching elements for the picture elements.

Heretofore, mostly lateral type TFTs have been employed as the switching elements. Lateral type TFTs with channel length dimensions of the order of 10 microns have proved adequate for the switching elements in low resolution displays. However, for display devices intended to display video or TV pictures and having a larger number of picture elements to provide desired higher resolution, fast switching of the elements and high frequency operating characteristics are required.

Moreover, it would be desirable for ease of manufacture and for reliability if the associated addressing (drive) circuit, for example, particularly the shift register circuit used for scanning the rows and picture elements, were to be integrated with the matrix on a common support, thus enabling the number of lead wires necessary to be decreased compared with known devices in which the shift register is a separately formed component requiring interconnection wires to be provided. Lateral type TFTs have been found lacking in this respect as their operation speed tends to be too slow to meet all the requirements of the address circuitry due to the low electron mobility and thus not suited to being used as elements of the shift register circuit. One approach to improving their operation speed would be to reduce the length of the channel. However, for lateral type TFTs the amount of reduction in channel length possible is restricted by limitations in the photoetching process used for delineating the source and drain, that is, the first and second, electrodes. The provision of large area arrays of TFTs complicates matters further.

Vertical type TFT structures have been proposed with a view to overcoming these problems as the length of the vertically-extending channel is not limited by any photoetching process and can be formed as low as 1 micron, thus greatly increasing the TFT'S speed of operation, this speed being proportional to the square of the channel length. Examples of known vertical type TFTs are described in the paper entitled "Proposed Vertical-Type Amorphous Silicon Field-Effect Transistors" by Y. Uchida et al published in IEEE Electric Device Letters, Vol. EDL 5, No. 4, April 1984.

The basic TFTs described in this paper comprise a glass support on which are deposited in succession, and superposed on one another, a metal layer, constituting the drain, an n⁺ a-Si layer followed by a n⁻a-Si layer, followed by another n⁺ a-Si layer and finally another metal layer, constituting the drain. Over a vertically-extending sidewall of these superimposed layers are deposited a gate insulation layer followed by a metal electrode constituting the gate. The gate and gate insulation layer hence extend substantially vertically. The channel is formed in the adjacent region of the n⁻a-Si layer and so the thickness of this layer determines the channel length.

Another form of known vertical type TFT is described in British Patent Specification 2139812A. In this TFT, source and drain electrode layers are deposited superimposed on one another on a support and spaced apart by an intermediate insulative layer. Over the vertically-extending sidewall of this structure is deposited a non-crystalline silicon layer followed by an insulative layer and an electrode layer forming the gate. In this case, the channel length effectively is defined by the thickness of the insulative layer separating the source and drain electrodes.

The performance of these known vertical-type TFTs in practice has not been found to be entirely satisfactory and problems in high frequency operating aspects of circuits embodying the TFTs have been experienced. In the case of the TFTs being used as switching elements, unwanted display effects are produced resulting in a quality of display less than could be expected.

Other forms of vertical type TFTs have also been proposed. In the English-language abstract of JP-A-61 32474 there is disclosed a vertical type TFT in which the source and drain electrodes are spaced apart in a direction orthogonally of the support and extend laterally of the support with the drain electrode overlying the source electrode to some extent. A stepped semiconductor layer extends over and vertically between the electrodes over which an insulator layer and an outwardly arranged gate electrode are provided. Its fabrication involves forming a temporary metal layer on the support which extends onto the source electrode and has a vertical sidewall overlying the source electrode. The drain electrode is then formed over this metal layer, and thereafter semiconductor and insulator layers are deposited. The metal layer is then removed leaving an air space between the source and drain electrodes to isolate them from one another. Finally, the gate electrode is formed above the source electrode and over the step of the semiconductor layer using, it appears, a conventional photolithographic process which results in a bulky gate electrode overlapping the source electrode by a considerable amount. Problems may be expected with this method in view of the use of the temporary metal layer and the lack of support to the drain electrode following its removal.

In the English-language abstract of JP-A-61 32475 there is disclosed a vertical type TFT with source and drain electrodes laterally offset on a support and with the source electrode being carried on a semiconductor layer so as to be spaced from the drain electrode in a direction orthogonal to the support. A bulky gate electrode is provided over the drain electrode and adjacent to a vertical sidewall of the semiconductor layer with insulator layers disposed therebetween. Fabrication of the TFT entails firstly forming the gate electrode using a conventional photolithographic process on top of the drain electrode. The gate electrode is then covered with insulator material defining a vertical surface in alignment with an edge of the drain electrode and thereafter the layer of semiconductor material is deposited on the support adjacent this vertical surface. The source electrode is then formed on the upper surface of the semiconductor layer.

It is an object of the present invention, to provide a vertical-type TFT which exhibits improved operational characteristics, particularly at higher frequencies, which can be manufactured simply and reliably, and which is suitable for use in active matrix addressed display devices.

According to a first aspect of the present invention there is provided a method of fabricating a thin film transistor comprising forming on a support having an insulative surface a stepped structure which has a step extending substantially vertically of the support surface and which comprises first and second thin film electrodes that are spaced apart from one another in a direction substantially orthogonal to the support by a layer of insulating or semiconductor material and are offset from one another laterally of the support surface and substantially do not overlie one another, with semiconductor material extending between the first and second thin film electrodes at the step and in contact with the first and second electrodes for providing a channel region, disposing a gate insulator layer followed by a layer of conductive material over the stepped structure, and thereafter defining the layer of conductive material using an anisotropic etching process so as to leave a region of the conductive material extending over the semiconductor material at the step constituting a gate electrode of the transistor which gate electrode extends substantially orthogonally to the support surface adjacent the step.

The method enables vertical type TFTs offering improved performance to be produced in a relatively simple and reliable manner. TFTs produced by this method offer better operating characteristics, particularly at higher frequencies, compared with the known devices. The invention stems from a recognition that a possible problem with the known vertical-type TFTs of the kind for example described in the paper by Uchide et al and GB-A-2139812 lies with the disposition of the source and drain electrodes with respect to one another which, it is thought, can result in a high parasitic capacitance between those electrodes which is believed to be responsible for the operational deficiencies especially noticable at higher operating frequencies. When used as switching elements in a matrix display, this can lead to inferior display quality. With the first and second electrodes of the TFT provided so as not substantially to overlap one another, the possibility of any significant parasitic capacitance is avoided. Moreover, in using an anistropic etching process to determine the gate electrode, the bulk of the gate electrode is minimised and autoregistration with the channel region is obtained thus reducing the possibility of capacitive coupling effects between the gate electrode and the first electrode in contrast to the TFTs produced using methods disclosed in the English-language abstracts of JP-A-61 32474 and JP-A-61 32475 which by their use of presumably conventional photolithographic processes to determine the gate electrode inevitably result in a very significant amount of overlap between their gate electrodes and first electrodes which can be expected to lead to significant capacitive coupling therebetween and consequently performance problems.

The semiconductor layer is preferably formed of amorphous silicon material but could comprise any other suitable material, for example amorphous gallium arsenide or cadmium selenide.

The gate electrode may be formed by anistropically etching a metal layer deposited on the gate insulator layer. Alternatively, the gate electrode may be formed by anisotropically etching resist material deposited over a metal layer disposed on the gate insulator layer and thereafter isotropically etching the metal layer. The latter technique has the advantage that there is less chance of damage being caused to the semiconductor layer due to etching.

In one embodiment of the method according to the present invention, the first and second electrodes are spaced apart orthogonally of the support surface by a layer of insulating material on the support and the semiconductor material is disposed as a layer extending over a sidewall of the insulating layer which determines the step, and the method includes further the step of defining the second electrode and the sidewall of the insulating layer by anisotropic etching of superimposed layers of insulating material and electrode material deposited on the support and extending over the first electrode. In this case, the thickness of the insultating layer, i.e. the height of the anisotropically etched sidewall, determines the channel length.

In another embodiment of the method according to the invention, the first and second electrodes are spaced apart orthogonally of the support surface by a layer of semiconductor material having a sidewall which defines the step of the stepped structure, and the method further includes the step of defining the second electrode and the sidewall of the semiconductor layer by anisotropic etching of semiconductor material and superimposed electrode material which are deposited on the support and extend over the first electrode. In this case, the height of the etched semiconductor layer sidewall determines the channel length.

In both embodiments, the step of anisotropically etching the superimposed layers may include depositing photosensitive resist material over the superimposed layers and exposing the resist material to illumination from beneath the first electrode, this electrode acting as a mask, whereby the sidewall is autoregistered with the edge of the first electrode. This autoregistration has the advantage that overlap of the first and second electrodes in the vertical direction is eliminated, thus further reducing source-drain capacitance. In both embodiments, a channel length around 1 micron can readily be achieved.

At least the first electrode of the first and second electrodes may comprise a conductive, for example, metal, layer and a layer of doped semiconductor material, for example n⁺a-Si, in contact therewith. In the embodiment using an insulating layer for determining the step, and hence the channel length, the semiconductor material may extend away from the step over the doped semiconductor layer. Alternatively, the said doped semiconductor layer may instead be formed by doping a region of the semiconductor material which extends away from the step over the conductive layer. This results in simpler processing as it becomes unnecessary to provide separate doped semiconductor layers for the electrodes.

According to a second aspect of the present invention there is provided a method of fabricating an array of TFTs in which each TFT is fabricated according to said first aspect and wherein the TFTs are fabricated simultaneously on a common support.

According to a third aspect of the present invention, there is provided a method of fabricating an active matrix addressed display device, for example a liquid crystal display device, which has a first support carrying an array of thin film transistors and picture element electrodes, a second, spaced, support and a display medium therebetween, wherein the array of thin film transistors on the first support is fabricated according to the method of the second aspect of the invention.

Thin film transistors, methods for their fabrication, and display devices incorporating such transistors, in accordance with the invention, will now be described, by way of example, with reference to the accompanying drawings, in which:-
Figure 1 is a schematic vertical section through one embodiment of a vertical-type thin film transistor according to the invention.
Figures 2a to 2c schematically illustrate various stages in the fabrication of the transistor of Figure 1;
Figure 3 is a schematic vertical section through another embodiment of a vertical-type TFT according to the invention;
Figure 4 is a plan schematic view of an active matrix addressed display device incorporating a plurality of transistors according to the invention for switching display signals to display elements of the device.

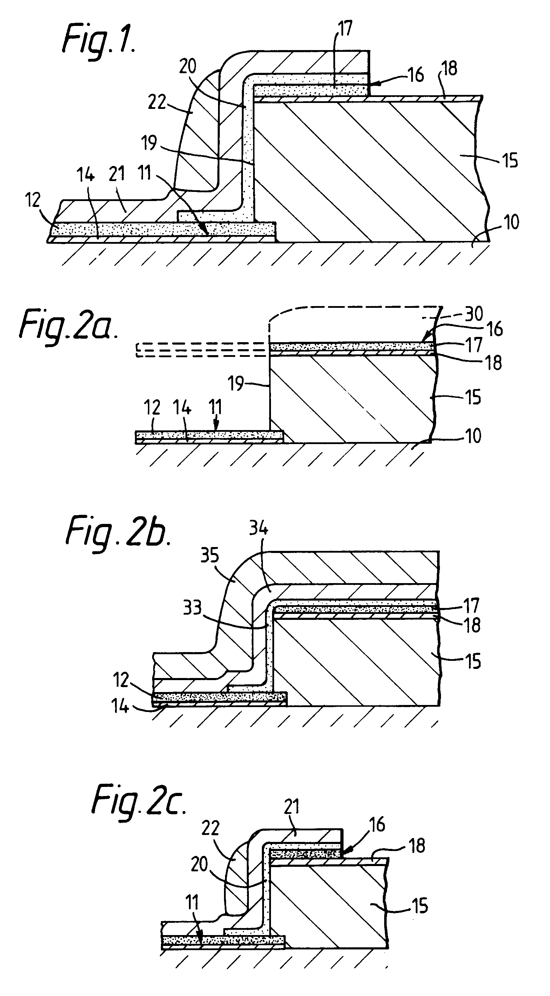

Referring to Figure 1, the vertical-type thin film transistor includes a first thin film electrode 11, constituting either the source or drain electrode of the transistor, and comprising a layer of doped semiconductor material 12 superimposed over a metal layer 14 carried on a substantially flat supporting substrate 10, at least the surface of which is electrically insulative. The metal layer 14 has a contact region (not shown) where it is connected to a supply line. This supply line may be formed integrally with the layer 14. Next to this electrode 11, there is deposited on the substrate 10 a dielectric layer 15 providing a step defined by a substantially flat sidewall 19 of the layer adjacent the edge of the first electrode 11 and extending generally vertically of the substrate 10. A very slight overlap between the electrode 11 and dielectric layer 15 as shown in Figure 1 is obtained due to the particular fabrication processes involved as will be described hereinafter. However, using other processes, the dielectric layer 15 could be defined with its sidewall abutting, but not overlapping, the edge of the electrode 11.

On the upper surface of the dielectric layer 15, which extends in a plane generally parallel with the substrate surface, there is deposited a second thin film electrode 16, constituting either the drain or source of the transistor as the case may be, which is spaced from the first electrode 11 in a direction orthogonal to the substrate 10 by the dielectric layer 15 and offset with respect to the first electrode 11 in the vertical direction. This electrode 16 comprises a metal layer 18 disposed directly on the surface of layer 15 and a superimposed doped semiconductor layer 17. The layer 17 is coextensive with the metal layer 18 at its end region, the metal layer extending beyond the layer 17 to provide a contact region.

Over the sidewall 19 of the insulator layer 15 there is deposited a layer 20 of semiconductor material providing the channel of the TFT, this layer 20 including end extension regions which overlie, and electrically contact with, the doped semiconductor layers 12 and 17 respectively of the electrodes 11 and 16. The semiconductor layer 20 is completely covered by a gate insulator layer 21 which, in turn, is followed directly by a metal layer 22 constituting the gate of the TFT. The gate layer 22 lies over the lower extension of the semiconductor layer 20, being physically separated therefrom by the insulator layer 21, and extends generally vertically alongside the semiconductor layer 20 to a level approximately adjacent the upper side of the upper extension of the semiconductor layer 20 overlying the second electrode 16.

In a practical embodiment, the metal layers 14 and 18 are formed of chromium and the gate metal layer 22 of a chromium/aluminium alloy. The insulator layers 15 and 21 are both formed of silicon nitride. The semiconductor layer comprises intrinsic amorphous silicon (i a-Si) and the doped semiconductor layers 12 and 17 are formed of n⁺ amorphous silicon (n⁺ a-Si). The substrate 10 conveniently is of glass. It will be appreciated, however, that any materials apparent to persons skilled in the art may be utilised instead of those specifically described above.

The semiconductor layer 20 overlying the sidewall of the insulator layer 20, as previously mentioned, serves to provide the channel region. Hence the height of the step defined by the insulator layer 15, that is, its thickness, determines the length of the channel region. This height may easily be formed at around 1 micron, thus producing a channel length of approximately corresponding value and enabling the TFT to operate at relatively high speeds and high frequencies compared with known lateral-type TFTs. Moreover, the length of the channel can readily be varied by appropriately varying the thickness of the insulator layer 15.

Because the vertically-spaced first and second electrodes 11 and 16, constituting the source and drain electrodes, are laterally shifted with respect to one another over the surface of the substrate 10 and substantially do not overlap one another in the vertical direction, operational problems of the kind associated with known TFTs caused by parasitic capacitance between source and drain electrodes are avoided with the configuration of TFT described. Whilst a slight amount of overlap, as indicated in Figure 1, is present in this particular embodiment this is negligible and has insignificant effect on the operation of the TFT.

A method of fabricating the TFT of Figure 1 will now be described with reference to Figures 2a to 2c. Firstly, a uniform layer of approximately 0.1 micron thickness of chromium is deposited directly on the substrate 10 by sputtering followed by a superimposed layer of doped semiconductor material (n⁺ a-Si) of uniform thickness of approximately 0.1 micron, by a chemical vapour disposition technique. The two layer structure is then defined into the required shape by etching to leave the layers 12 and 14 of the first electrode 11, and integral lateral extensions of the layers (not shown) on the substrate 10 for contact purposes.

A silicon nitride dielectric layer, eventually forming the layer 15, is then disposed over both the first electrode 11 and the adjacent exposed surface area of the substrate 10 to around 1 micron in thickness by chemical vapour deposition. Over the exposed upper surface of this dielectric layer are deposited, in succession, a chromium layer and a doped semiconductor (n⁺ a-Si) layer, both to a uniform thickness of approximately 0.1 microns in similar manner to the layers constituting the first electrode 11. These layers eventually constitute the second electrode 16.

A photosensitive resist layer 30, indicated by a dotted line in Figure 2a, is deposited over a portion of the surface of the upper doped semiconductor layer, and selected regions thereof in a predetermined relation to the first electrode 11 are then illuminated vertically through a mask. The shaped chromium layer 18, doped semiconductor layer 17 and dielectric layer 15 of the TFT are then defined anisotropically by subjecting the upper doped semiconductor and chromium layers and the dielectric layer to a dry etch which removes areas of those layers not covered by the resist material, as illustrated in Figure 2a.

This anisotropic definition results in the upper chromium and doped semiconductor layers being co-terminous with the dielectric layer and in the dielectric layer 15 having a substantially vertically extending sidewall 19.

Although in ideal circumstances the sidewall of the layer 15 could be aligned with the edge of the first electrode 11, such that the lower edge of the sidewall lies on the surface of the substrate 10 and abuts the upstanding edge of the first electrode 11, this might be difficult to achieve in practice in view of limitations in accurately positioning the mask for the resist. Therefore, the position of the sidewall 19 as determined by the location of the mask through which the resist 30 is illuminated, is deliberately biased slightly in the direction towards the first electrode to allow for the possibility of some lateral inaccuracy of positioning of the resist mask in the definition stage and to ensure direct contact between the defined dielectric layer 15 and the first electrode 11. Thus, as shown in the figures, the sidewall 19 will tend to lie on the upper surface of the first electrode 11 closely adjacent its upstanding edge.

Referring now to Figure 2b, a layer 33 of undoped semiconductor material (i a-Si) of substantially uniform thickness of approximately 0.1 microns is deposited by chemical vapour deposition over the upper side of the doped semiconductor layer 17, the sidewall 19, and partly over the first electrode 11. This is followed by a silicon nitride layer 34, to form the gate insulator layer 21, and a metal layer of a chromium/aluminium alloy as indicated at 35. The metal layer 35 is then etched anisotropically to leave a predetermined region thereof, as shown in Figure 2c overlying the extension of the semiconductor material layer on the first electrode 11 and forming the gate electrode 22 and, with the aid of a mask, one or more integral extensions forming a gate interconnection line which extends in a direction perpendicular to the plane of the paper.

Finally, unwanted portions of the gate insulator layer 34, the semiconductor layer 33, the doped semiconductor layer 17 and metal layer 18 on the upper side of the layer 15 are etched away as shown in Figure 2c to define a second electrode 16, the metal layer 18 thereof being left with an integral lateral extension via which contact can be made with the second electrode 16. Electrical contact with the first electrode 11 is accomplished by forming a window opening in the layer 12 down to the metal 14 at any convenient point (not shown).

Whilst the fabrication process is slightly more complex than that required for a conventional lateral TFT and, in this particular embodiment, involves some anistropic definitions, it enables short channel devices, capable of high speed and high frequency operation, to be made without any fine geometry lithography. Moreover, in the described fabrication process, the gate of the TFT is autoregistered with the channel thereby resulting in a reduction of feed-back capacitance between the gate and the first electrode, this reduction being very important for fast, stable, circuits incorporating the TFT.

A number of modifications are possible to the described TFT and its fabrication process.

Rather than providing separate doped semiconductor layers 12 and 17 forming part of the first and second electrodes 11 and 16 respectively, these layers could be omitted and the desirable doped semiconductor components of these electrodes provided instead by selective implantation doping of the semiconductor material layer 20 constituting the channel. Referring to Figure 2b, therefore, the doped semiconductor layers 12 and 17 are omitted and following deposition of the layer 33 of i a-Si material, an implantation doping operation, using, for example, phosphorus, is carried out to dope the lower regions of the thickness of the extensions of the semiconductor layer 33 overlying the metal layers 14 and 18. The implantation doping is applied vertically of the substrate 10 so that the portion of the semiconductor layer 33 adjacent the sidewall 19 of the dielectric layer 15 remains undoped. This alternative form of fabrication offers the advantage of simpler processing since the number of separate layers needed to be deposited is reduced.

A further variation would be to deposit and define the doped semiconductor layer 12 as described originally and to form the doped semiconductor layer of the second electrode 16 by implantation doping of the extension of the semiconductor layer 33 overlying the layer 18. This variation avoids the metal layer 14 contacting directly undoped semiconductor material of the layer 33 at the bottom of the channel region (which would remain undoped if implantation doping were to be used) and ensures that the channel length relates very closely to the height of the step of the dielectric layer 15.

The slight overlap between the first electrode 11 and the dielectric layer 15, and hence the second electrode 16, can be removed using a modified fabrication process. In this modified process, the definition of the sidewall 19 of the dielectric layer 15 is accomplished by illuminating the structure shown in Figure 2a, including the photosensitive resist layer 30, from the back, that is, through the glass substrate 10, such that the metal layer 14 now acts as the mask determining the regions of the resist layer 30 which are exposed. The sidewall of the dielectric layer is thus autoregistered with the upstanding edge of the first electrode 11. In this process, it is necessary that the upper metal layer 18 be formed of transparent conductive material to allow light to reach the resist layer 30. Indium tin oxide may be used for this purpose. Such autoregistration of the sidewall of the dielectric layer 15 with the edge of the first electrode 11 reduces any possibility of source-drain capacitance still further.

While the step of defining the substantially vertical sidewall 19 of the dielectric layer 15 using an anisotropic etching technique is preferred, it is envisaged that this sidewall could alternatively be defined using isotropic etching with the etch rate of the nitride material being varied through the thickness by progressively changing the deposition conditions. This technique reduces the risk of adverse damage effects, particularly to the gate insulator layer 21 and the semiconductor layer 21.

In a further modification of the fabrication process, the metal gate layer 22 can be formed by anisotropically etching resist material deposited over the metal layer 35 used to form the gate layer and subsequently isotropically etching the metal. This has the advantage that the possibility of damage to the semiconductor layer 33 due to etching is reduced.

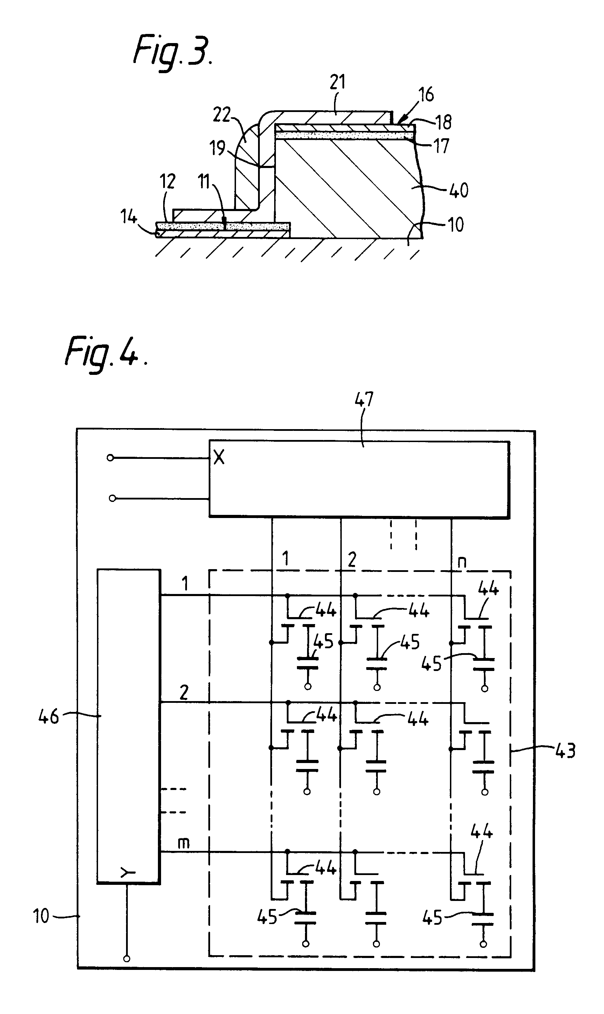

Referring now to Figure 3, there is shown schematically in section a second embodiment of TFT in accordance with the present invention. For simplicity, the same reference numerals are used for components of the TFT general corresponding to those of the embodiment shown in Figures 1 and 2. The major difference with this embodiment is that the layer 33 of undoped semiconductor material is not used and instead the step-defining layer 40, equivalent to layer 15 in the earlier embodiment, is itself formed of undoped semiconductor material (i a-Si) rather than of insulative silicon nitride. As a consequence, it is necessary that the order of the layers of the second electrode 16 be reversed with the doped semiconductor material layer 17 lying beneath the metal layer 18 and in contact with the thick layer 40. In this embodiment, the region of the layer 40 immediately adjacent its substantially vertical sidewall 19 acts as the channel region of the device. In the version shown it is necessary that the layer 40 slightly overlaps the first electrode 11 adjacent its edge so that the doped semiconductor layer 12 of the first electrode contacts the channel region. Alternatively the doped semiconductor layer 12 could be extended over the edge of metal layer 14 to contact the semiconductor layer 40, thus allowing the sidewall 19 to be aligned with the edge of the electrode 11.

This embodiment offers the advantage of simpler processing. However, there may be a penalty in that a higher off-current of the device could exist due to space charge limited currents. Fabrication of this embodiment of TFT is essentially the same as that described with respect to Fgiures 2a to 2c except that semiconductor material is used for the layer 15 and the semiconductor layer 20 and its attendant extensions are omitted.

A plurality of the described TFTs may be formed simultaneously in any array using a common substrate 10. The TFTs can be arranged in any desired array, for example a matrix array consisting of rows and columns of TFTs as would be required for use as pixel switching elements in an active matrix addressed display device such as a liquid crystal, electrochromic or electroluminescent display device. The required interconnection between TFTs of the array can conveniently be established during deposition of metal layers. For example, the source electrodes, (e.g. the first electrodes 11) of the TFTs of all the TFTs in one column of a column and row matrix array may be interconnected via integral extensions formed simultaneously with the metal layer 14 of the TFTs' first electrodes 11. Likewise, the gate electrodes of all TFTs in one row of the matrix array can be interconnected via integrally-formed extensions of the electrodes 22. The pixel electrodes may be formed simultaneously with, and connected to respective ones of, the second electrodes 16.

Figure 4 illustrates diagrammatically a typical example of a display device, utilising TFTs according to the invention. Such active matrix addressed display devices are generally well known and have been widely documented. For this reason it is felt unnecessary to provide a detailed description here. Briefly, however, and as shown in Figure 4, the TFTs, here designated by the reference numeral 44, share a common substrate 10 and are arranged in rows (1-m) and columns (1-n) with the source electrodes of the TFTs of each column and the gate electrodes of the TFTs of each row respectively being interconnected in column and row lines. The drain electrodes, 16, of the TFTs are connected to respective picture element electrodes 45 carried on the substrate 10 adjacent to, and laterally spaced from the TFTs. These picture element electrodes 45 together with respective corresponding regions of a common electrode carried on a further substrate of glass spaced from the substrate 10 carrying the TFTs, (the substrate 10 serving in this case as one substrate of the device), and display medium therebetween constitute picture elements. The actual display area of the device is indicated by dotted line 43 in Figure 4. The display medium may in this example comprise liquid crystal material. In operation, the rows of TFTs are repetitively and sequentially addressed. A scanning signal is applied to a row line to turn the TFTs in that row "on". When turned on, the TFTs form conductive paths between their source lines (columns) and their associated picture element electrodes. Simultaneously with each row being turned on, video information signals are applied to the appropriate columns which are passed through the TFTs of the "on" row and charge up the associated picture elements. When the row of TFTs is turned "off" upon cessation of gate line voltage, the video information voltages are maintained across the picture elements until the next time that row is addressed, this being every field period. The TFTs of the present invention are particularly suitable for allowing TV pictures to be displayed in view of their high speed and high frequency operation capability, and enable a matrix array of picture elements comprising the large numbers of rows and columns needed to provide adequate display resolution to be readily achieved.

Besides acting as picture element switching elements in the aforementioned manner, the TFTs are used additionally for the associated driving circuitry, for example as elements of a shift register circuit for sequentially addressing the gates of the TFTs of rows of the matrix array as indicated at 46 and video signal analogue shift registers/sample and hold circuits for providing line at a time serial to parallel conversion for addressing the columns of source-interconnected TFTs as indicated at 47. Such addressing circuitry is incorporated on the substrate 10 with the TFTs thereof being fabricated simultaneously with the picture element switching TFTs. The TFTs of the addressing circuitry need to be fast and capable of high frequency operation more so than the picture element TFTs, and thus the vertical type TFT of the present invention is particularly beneficial for this purpose.

## Claims

1. A method of fabricating a thin film transistor comprising forming on a support (10) having an insulative surface a stepped structure which has a step extending substantially vertically of the support surface and which comprises first and second thin film electrodes (11,16) that are spaced apart from one another in a direction substantially orthogonal to the support by a layer of insulating or semiconductor material (15,40) and are offset from one another laterally of the support surface and substantially do not overlie one another, with semiconductor material (20,40) extending between the first and second thin film electrodes at the step and in contact with the first and second electrodes for providing a channel region, disposing a gate insulator layer (21) followed by a layer of conductive material (35) over the stepped structure, and thereafter defining the layer of conductive material (35) using an anisotropic etching process so as to leave a region (22) of the conductive material extending over the semiconductor material (20,40) at the step constituting a gate electrode of the transistor which gate electrode extends substantially orthogonally to the support surface adjacent the step.

2. A method according to Claim 1, characterised in that the gate electrode (22) is formed by anisotropically etching a metal layer (35) deposited on the gate insulator layer (21).

3. A method according to Claim 1, characterised in that the gate electrode (22) is formed by anisotropically etching resist material deposited over a metal layer (35) disposed on the gate insulator layer (21) and thereafter isotropically etching the metal layer.

4. A method according to any one of Claims 1 to 3, characterised in that the first and second electrodes (11,16) are spaced apart orthogonally of the support surface by a layer of insulating material (15) on the support surface and the semiconductor material (20) is disposed as a layer extending over a sidewall (19) of the insulating layer which determines the step, and in that the method further includes the step of defining the second electrode (16) and the sidewall (19) of the insulating layer by anisotropic etching of superimposed layers of insulating material and electrode material deposited on the support and extending over the first electrode (11).

5. A method according to any one of Claims 1 to 3, characterised in that the first and second electrodes (11,16) are spaced apart orthogonally of the support surface by a layer of semiconductor material (40) having a sidewall (19) which defines the step of the stepped structure and in that the method further includes the step of defining the second electrode (16) and the sidewall (19) of the semiconductor layer by anisotropic etching of a layer of semiconductor material and superimposed electrode material which are deposited on the support and extend over the first electrode (11).

6. A method according to Claim 4 or 5, characterised in that the step of anisotropically etching the superimposed layers includes depositing photosensitive resist material (30) over the superimposed layers and exposing the resist material to illumination from beneath the first electrode (11), this electrode acting as a mask, whereby the sidewall (19) is autoregistered with an edge of the first electrode (11).

7. A method according to any one of Claims 1 to 6, characterised in that at least the first electrode of the first and second electrodes comprises a conductive layer (14,18) and a layer of doped semiconductor material (12,17) in contact therewith.

8. A method according to Claim 4 and Claim 7, characterised in that said semiconductor material (20) extends away from the step over the doped semiconductor layer (12,17).

9. A method according to Claim 4 and Claim 7, characterised in that the doped semiconductor layer is formed by doping a region of said semiconductor material (20) of the stepped structure which extends away from the step over the conductive layer (14,18) of the electrode.

10. A method of fabricating an array of thin film transistors, wherein each transistor of the array is fabricated according to the method of any one of Claims 1 to 9 simultaneously on a common support.

11. A method of fabricating an active matrix addressed display device having a first support carrying an array of thin film transistors and an array of picture element electrodes, a second, spaced, support and a display medium therebetween, wherein the array of thin film transistors on the first support is fabricated according to the method of Claim 10.

## Patentansprüche

1. Verfahren zum Herstellen eines Dünnfilmtransistors, das die Bildung einer gestuften Struktur auf einem Träger (10) mit einer Isolierfläche, wobei die Struktur eine Stufe hat, die sich im wesentlichen vertikal zur Trägerfläche erstreckt und erste und zweite Dünnfilmeletroden (11, 16) enthält, die durch eine Schicht (15,40) aus Isolier- oder Halbleitermaterial in einer Richtung im wesentlichen orthogonal zum Träger voneinander getrennt, lateral zur Trägerfläche gegeneinander verschoben sind und im wesentlichen einander nicht überlagern, wobei sich Halbleitermaterial (20, 40) zwischen den ersten und zweiten Dünnfilmelektroden an der Stufe erstreckt und zur Bildung eines Kanalgebiets mit den ersten und zweiten Elektroden in Kontakt steht, die Anbringung einer Gate-Isoliersehicht (21) mit einer nachgeschalteten Schicht (35) aus Leitermaterial (35) auf der gestuften Struktur und danach die Definierung der Schicht aus Leitermaterial (35) unter Verwendung eines anisotropischen Ätzverfahrens umfaßt, um ein sich über das Halbleitermaterial (20, 40) erstreckendes Gebiet (22) des Leitermaterials auf der Stufe zurückzulassen, die eine Gate-Elektrode des Transistors bildet, wobei die Gate-Elektrode sich im wesentlichen orthogonal zur Trägerfläche neben der Stufe erstreckt.

2. Verfahren nach Anspruch 1, dadurch gekennzeichnet, daß die Gate-Elektrode (22) durch anisotropisches Ätzen einer auf der Gate-Isolierschicht (21) niedergeschlagenen Metallschicht (35) erzeugt wird.

3. Verfahren nach Anspruch 1, dadurch gekennzeichnet, daß die Gate-Elektrode (22) durch anisotropisches Ätzen von auf einer Metallschicht (35) abgelagertem Resistmaterial, wobei die Metallschicht (35) auf der Gate-Isolierschicht (21) angeordnet ist, und durch anschließendes isotropisches Ätzen der Metallschicht gebildet wird.

4. Verfahren nach einem der Ansprüche 1 bis 3, dadurch gekennzeichnet, daß die ersten und zweiten Elektroden (11, 16) durch eine Schicht aus Isoliermaterial (15) auf der Trägerfläche im Abstand voneinander orthogonal zur Trägerfläche angeordnet sind und das Halbleitermaterial (20) als eine Schicht angebracht wird, die sich über eine Seitenwand (19) der Isolierschicht erstreckt, die die Stufe bestimmt, und das Verfahren weiter den Schritt der Definition der zweiten Elektrode (16) und der Seitenwand (19) der Isolierschicht durch anisotropisches Ätzen überlagerter Schichten aus Isoliermaterial und Elektrodenmaterial umfaßt, das auf dem Träger abgelagert ist und sich über die erste Elektrode (11) erstreckt.

5. Verfahren nach einem der Ansprüche 1 bis 3, dadurch gekennzeichnet, daß die ersten und zweiten Elektroden (11, 16) durch eine Schicht aus Halbleitermaterial (40) mit einer Seitenwand (19) im Abstand voneinander orthogonal zur Trägerfläche angeordnet sind, wobei die Seitenwand die Stufe der Struktur bestimmt, und das Verfahren weiter den Schritt der Definition der zweiten Elektrode (16) und der Seitenwand (19) der Halbleiterschicht durch anisotropisches Ätzen des Halbleitermaterials und des überlagerten Elektrodenmaterials umfaßt, die auf dem Träger abgelagert sind und sich über die erste Elektrode (11) erstrecken.

6. Verfahren nach Anspruch 4 oder 5, dadurch gekennzeichnet, daß der Schritt des anisotropischen Ätzens der überlagerten Schichten das Ablagern von photosensitivem Resistmaterial (30) auf den überlagerten Schichten und das Beleuchten des Resistmaterials von unter der ersten Elektrode (11) umfaßt, wobei diese Elektrode als Maske dient und die Seitenwand (19) mit einem Rand der ersten Elektrode (11) selbstausgerichtet wird.

7. Verfahren nach einem der Ansprüche 1 bis 6, dadurch gekennzeichnet, daß wenigstens die erste Elektrode der ersten und zweiten Elektroden eine leitende Schicht (14, 18) und eine damit in Kontakt stehende Schicht aus dotiertem Halbleitermaterial (12, 17) enthält.

8. Verfahren nach Anspruch 4 und 7, dadurch gekennzeichnet, daß das Halbleitermaterial (20) sich von der Stufe auf der dotierten Halbleiterschicht (12, 17) weg erstreckt.

9. Verfahren nach Anspruch 4 und 7, dadurch gekennzeichnet, daß die dotierte Halbleiterschicht durch Dotieren eines Gebiets des Halbleitermaterials (20) der gestuften Struktur erzeugt wird, die sich von der Stufe auf der dotierten Halbleiterschicht (14, 18) weg erstreckt.

10. Verfahren zum Herstellen einer Gruppe von Dünnfilmtransistoren, worin jeder Transistor der Gruppe mit dem Verfahren nach einem der Ansprüche 1 bis 9 gleichzeitig auf einem gemeinsamen Träger hergestellt wird.

11. Verfahren zum Herstellen einer aktiven matrixadressierten Wiedergabeanordnung mit einem ersten Träger, der eine Gruppe von Dünnfilmtransistoren und eine Gruppe von Bildelementelektroden, einen zweiten im Abstand liegenden Träger und dazwischen ein Wiedergabemedium trägt, worin die Gruppe der Dünnfilmtransistoren auf dem ersten Träger mit dem Verfahren nach Anspruch 10 hergestellt ist.

## Revendications

1. Procédé de fabrication d'un transistor à couches minces selon lequel on forme, sur un support (10) comportant une surface isolante, une structure à gradin qui comporte un gradin s'étendant en substance verticalement par rapport à la surface de support et qui comprend une première et une seconde électrode à couche mince (11, 16) qui sont espacées l'une de l'autre dans une direction en substance orthogonale au support par une couche de matière isolante ou semi-conductrice (15, 40) et qui sont décalées l'une de l'autre latéralement par rapport à la surface de support et ne se recouvrent sensiblement pas l'une l'autre, de la matière semi-conductrice (20, 40) s'étendant entre la première et la seconde électrode à couche mince au niveau du gradin et en contact avec la première et la seconde électrode pour fournir une région de canal, on dispose une couche isolante de grille (21), suivie d'une couche de matière conductrice par-dessus la structure à gradin, puis on définit la couche de matière conductrice à l'aide d'un procédé d'attaque chimique anisotrope de manière à laisser une région (22) de la matière conductrice qui s'étend par-dessus la matière semi-conductrice (20, 40) au niveau du gradin, constituant une électrode de grille du transistor, électrode qui s'étend en substance orthogonalement par rapport à la surface de support, à proximité immédiate du gradin.

2. Procédé suivant la revendication 1, caractérisé en ce qu'on forme l'électrode de grille (22) en attaquant chimiquement de manière anisotrope une couche de métal (35) déposée sur la couche isolante de grille (21).

3. Procédé suivant la revendication 1, caractérisé en ce qu'on forme l'électrode de grille (22) attaquant chimiquement de manière anisotrope la matière de réserve déposée sur une couche de métal (35) disposée sur la couche isolante de grille (21) puis en attaquant chimiquement de manière isotrope la couche de métal.

4. Procédé suivant l'une quelconque des revendications 1 à 3, caractérisé en ce que la première et la seconde électrode (11, 16) sont espacées l'une de l'autre orthogonalement par rapport à la surface de support par une couche de matière isolante (15) sur la surface de support et la matière semi-conductrice (20) est disposée sous forme d'une couche s'étendant sur une paroi latérale (19) de la couche isolante qui détermine le gradin, et en ce que le procédé comprend, en outre, l'opération consistant à définir la seconde électrode (16) et la paroi latérale 19 de la couche isolante en attaquant chimiquement de manière anisotrope des couches superposées de matière isolante et de matière d'électrode déposées sur le support et s'étendant par-dessus la première électrode (11).

5. Procédé suivant l'une quelconque des revendications 1 à 3, caractérisé en ce que la première et la seconde électrode (11, 16) sont espacées l'une de l'autre orthogonalement par rapport à la surface de support par une couche de matière semi-conductrice (40) comportant une paroi latérale (19) qui définit le gradin de la structure à gradin et que le procédé comprend, en outre, l'opération consistant à définir la seconde électrode (16) et la paroi latérale (19) de la couche semi-conductrice en attaquant chimiquement de manière anisotrope une couche de matière semi-conductrice et de matière d'électrodes superposées qui sont déposées sur le support et s'étendent pardessus la première électrode (11).

6. Procédé suivant la revendication 4 ou 5, caractérisé en ce que l'opération consistant à attaquer chimiquement de manière anisotrope les couches superposées comprend le dépôt d'une matière de réserve photosensible (30) par-dessus les couches superposées et l'exposition de la matière de réserve à une illumination venant d'en dessous de la première électrode (11), cette électrode servant de masque, de sorte que la paroi latérale (19) est autoalignée avec un bord de la première électrode (11).

7. Procédé suivant l'une quelconque des revendications 1 à 6, caractérisé en ce qu'au moins la première électrode des première et seconde électrodes comprend une couche conductrice (14, 18) et une couche de matière semi-conductrice dopée (12, 17) en contact avec elle.

8. Procédé suivant les revendications 4 et 7, caractérisé en ce que ladite matière semi-conductrice (20) s'étend dans un sens s'éloignant du gradin par-dessus la couche semi-conductrice dopée (12, 17).

9. Procédé suivant les revendications 4 et 7, caractérisé en ce qu'on forme la couche semi-conductrice dopée en dopant une région de la matière semi-conductrice (20) de la structure à gradin qui s'étend dans un sens s'éloignant du gradin par-dessus la couche conductrice (14, 18) de l'électrode.

10. Procédé de fabrication d'un réseau de transistors à couches minces dans lequel chaque transistor du réseau est fabriqué conformément au procédé de l'une quelconque des revendications 1 à 9, et simultanément sur un support commun.

11. Procédé pour fabriquer un dispositif d'affichage adressé par matrice active comportant un premier support portant un réseau de transistors à couches minces et un réseau d'électrodes d'éléments d'image, un second support espacé et un agent d'affichage entre eux, dans lequel le réseau de transistors à couches minces sur le premier support est fabriqué conformément au procédé de la revendication 10.
